# EUROPEAN PATENT APPLICATION

(11) **EP 4 535 960 A2**
(43) Date of publication of application: **09.04.2025**
(21) Application number: 24025012.6
(22) Date of filing: 04.10.2024
(51) Int. Cl.: H10F 30/223, H10F 77/122, H10F 77/14, H10F 77/20, H10F 77/40

(54) **A PHOTODIODE WITH AN INTERFACE REGION TO REDUCE A BAND OFFSET BETWEEN A CHARGE CARRIER GENERATING REGION AND A DOPED REGION**

(30) Priority: 05.10.2023 US 202363542553 P; 16.10.2023 US 202363544286 P
(71) Applicant: Ranovus Inc., Kanata, Ontario K2K 2X1 (CA)
(72) Inventor: Beckett, Douglas J. S., Kanata, K2L 1Z3 (CA)
(74) Representative: Richardt Patentanwälte PartG mbB

(57) **Abstract**

A photodiode (200) comprises a carrier generating region (206) of a semiconductor having a bandgap that absorbs light (205) of a given wavelength, such that electrical charge carriers are generated therein. The photodiode further comprises a n-doped (210) and a p-doped (208) semiconductor region having respective bandgaps higher than the bandgap of the carrier generating region, the respective bandgaps being transparent to the light of the given wavelength, the n-doped and p-doped semiconductor region being along different sides of the carrier generating region. The photodiode further comprises an interface region (211) between the carrier generating region and a given doped region of the n-doped and the p-doped semiconductor region, the interface region comprising one or more of a semiconductor alloy and a semiconductor sequence that is one or more of graded and stepped in composition, selected to reduce a band offset (222) between the carrier generating region and the given doped region adjacent the interface region.

## Description

### CROSS-REFERENCE TO RELATED APPLICATIONS

This application claims priority from both US Provisional Patent Application having Serial Number 63/542553, filed on October 5, 2023, and US Provisional Patent Application having Serial Number 63/544286, filed on October 16, 2023, and the entire contents of each is incorporated herein by reference.

### FIELD

The present specification relates generally to telecommunication devices, and specifically to a photodiode with an interface region to reduce a band offset between a carrier generating region and a doped region.

### BACKGROUND

Photodiode saturation, and/or a reduction in linear power range of a photodiode may be due to the reduction in the electric field in an absorbing region that generates carriers, which may also be referred to as a carrier generating region and/or an active layer and/or active region. This electric field reduction is generally caused by "carrier screening", in which the charge carriers (electrons and holes), generated by the absorption of light in the absorbing region, produce their own electric field which is in opposition to an electric field applied to the photodiode. Photodiode linearity may be increased at the expense of responsivity. For example, a photodiode may be engineered to reduce the amount of light absorbed per unit length (fewer charge carriers per unit volume), or to increase the volume of absorbing region. However, reducing the amount of light absorbed per unit length increases linearity at the expense of reduced responsivity. Furthermore, increasing the volume of the absorbing region reduces the modulation bandwidth (speed) of a photodiode.

### BRIEF DESCRIPTIONS OF THE DRAWINGS

For a better understanding of the various implementations described herein and to show more clearly how they may be carried into effect, reference will now be made, by way of example only, in which:
FIG. 1 depicts a Si-Ge-Si heterostructure photodiode, according to the prior art.
FIG. 2 depicts a photodiode with an interface region of a graded semiconductor alloy to reduce a band offset between a carrier generating region and a doped region, according to non-limiting examples.
FIG. 3 depicts a photodiode with an interface region of a stepped semiconductor sequence to reduce a band offset between a carrier generating region and a doped region, according to non-limiting examples.
FIG. 4 depicts a photodiode with an interface region of a graded semiconductor alloy to reduce a band offset between a carrier generating region and a doped region, according to other non-limiting examples.
FIG. 5 depicts a photodiode having a stacked architecture with an interface region of a graded semiconductor alloy to reduce a band offset between a carrier generating region and a doped region, according to other non-limiting examples.
FIG. 6 depicts a graph of bandgap of a silicon/germanium alloy as a function of fraction germanium content.

Skilled artisans will appreciate that elements in the figures are illustrated for simplicity and clarity and have not necessarily been drawn to scale. For example, the dimensions of some of the elements in the figures may be exaggerated relative to other elements to help to improve understanding of embodiments of the present invention.

The apparatus and method components have been represented where appropriate by conventional symbols in the drawings, showing only those specific details that are pertinent to understanding the embodiments of the present invention so as not to obscure the disclosure with details that will be readily apparent to those of ordinary skill in the art having the benefit of the description herein.

### DETAILED DESCRIPTION

High modulation-bandwidth optical receivers must generally operate over a standardized range of input power. A reduction has been measured in certain high modulation-bandwidth optical receivers, in a range over which the photocurrent increases linearly with the input optical power. Concurrently with this reduction in the differential responsivity (e.g., which may be characterized by a changed slope in photocurrent relative to a change in optical input power), a reduction in modulation bandwidth (photodiode speed of response) has been measured. This reduction in a slope of responsivity and/or in modulation bandwidth as optical input power is increased can be called "saturation".

The present specification provides for photodiodes which increase the optical input power at which photodiodes saturate; for example, such photodiodes increase the range over which the photocurrent increases linearly with the input optical power. In addition, the presently provided photodiodes generally allow a given modulation bandwidth (photodiode speed of response) to be maintained. In particular, photodiodes as provided herein include an interface region between a carrier generating region and a given doped region (e.g., an n-doped semiconductor region or a p-doped semiconductor region); the interface region comprises one or more of a semiconductor alloy and a semiconductor sequence that is one or more of graded and stepped in composition, and the semiconductor alloy and/or semiconductor sequence is selected to reduce a band offset between the carrier generating region and the given doped region adjacent the interface region.

For example, in the interface region, closest to the carrier generating region, an alloy of respective semiconductors used in the fabrication of the carrier generating region and the given doped region may be used that has a bandgap (the difference between valence band energy and conduction band energy) that is greater than the bandgap of the carrier generating region, but still less than the bandgap of the given doped region. Such a configuration reduces the band offset between the carrier generating region and the given doped region, and generally reduces carrier screening effects. Furthermore, the semiconductors of the interface region may change in their respective content (e.g., via grading and/or stepping, as described herein) to increase the modulation bandwidth by reducing the carrier transport time over a distance from the carrier generating region to the given doped region. Furthermore, the semiconductors of the interface region are selected such that the interface region is transparent to light that is absorbed by the carrier generating region so that carrier generation is contained in the carrier generating region.

Such interface regions may also generally increase the responsivity of the photodiodes and reduce undesirable dark current, relative to prior art photodiodes that do not include such an interface region.

Furthermore, in some specific examples, such an interface region may be included in photodiodes of photonic integrated circuits (PICs), that may be fabricated made from intrinsic germanium (e.g., as the carrier generating region) deposited between n-doped and p-doped silicon electronic contact regions (e.g., as the doped regions).

Furthermore, using germanium and silicon as an example, the presently provided photodiodes may generally include "grading" and/or "stepping" of the normally abrupt interface between the silicon and germanium regions. For example, grading may be understood to mean that an alloy of silicon and germanium, provided in the interface region, is graded over a finite and/or given distance so that the interface region between the silicon and germanium regions is higher in germanium content closer to the germanium region and gradually becomes higher in silicon content closer to the silicon region. Furthermore, stepping may be understood to mean that sequential layers of combinations of silicon and germanium is provided in the interface region in a sequence of steps and/or layers, over a finite and/or given distance, so that the interface region between the silicon and germanium regions is higher in germanium content, on average, closer to the germanium region and gradually becomes higher in silicon, on average, content closer to the silicon region.

Continuuing with the example of silicon and germanium, to fabricate the presently provided photodiodes, a process may be introduced in fabrication of photodiodes and/or PICs that allows for generation of silicon/germanium alloyed material and/or steps of combinations of silicon and germanium. Any suitable method for generation of silicon/germanium alloyed material and/or steps is within the scope of the present specification, including, but not limited to, growth of a graded silicon/germanium alloyed material and/or steps, and/or implantation techniques to generate the graded silicon/germanium alloyed material.

The presently provided photodiodes may be similar to prior art photodiodes made from doped silicon and intrinsic germanium, but with "grading" and/or "stepping" of the normally abrupt interface between p-doped silicon and intrinsic germanium regions. Such presently provided photodiodes generally show improved linearity and responsivity over prior art photodiodes made from doped silicon and intrinsic germanium with abrupt interfaces.

Put another way, the presently provided photodiodes may comprise an alloyed interface between an absorbing germanium carrier generating region and a p-doped silicon contact region to reduce a valence-band offset and therefore a barrier to hole transport. Such a structure generally increases the range of linearity (power at which saturation occurs) in a germanium-on-silicon PIC photodiode.

While certain examples herein that are described with respect to an interface region between an absorbing germanium carrier generating region and a p-doped silicon contact region, more generally, such respective interface regions may be provided between a carrier generating region and respective given doped semiconductor regions (e.g., contact regions), whether n-doped or p-doped, to reduce any respective band offsets.

In some examples, where the presently provided photodiodes comprises an alloyed interface between an absorbing intrinsic germanium carrier generating region and a p-doped silicon contact region, an interface alloy composition may comprise: graded and/or stepped non-absorbing higher-bandgap materials placed near, or within, the doped regions, or near, or within the germanium region, which generally increases responsivity due to light absorbed by the absorbing intrinsic germanium carrier generating region. Such transparency generally reduces and/or eliminates the number of carriers generated in the interface region. The reduction in carrier-concentration in turn reduces light wasted due to free-carrier absorption (FCA), for example as photocurrent may not be generated with FCA, and which may generate unwanted heat.

Such graded and/or stepped non-absorbing higher-bandgap materials may further decrease the dark current in a germanium-on-silicon PIC photodiodes. Put another way, by example, an abrupt interface between an absorbing region and a doped contact-region of a prior art photodiode may be replaced by an interface region of graded and/or stepped non-absorbing higher-bandgap materials, and dark current may be generally reduced due to increasing thermal activation energy.

While certain examples herein are described with respect to an interface layer between an absorbing germanium region and a p-doped silicon contact region, such interface layers may be used with photodiodes fabricated from other semiconductors and/or materials.

Indeed, more generically, photodiodes provided in the present specification may include: a carrier generating region comprising a semiconductor having a bandgap absorbing light of a given wavelength, such that electrical charge carriers are generated in the carrier generating region by the light of the given wavelength; an n-doped semiconductor region and a p-doped semiconductor region having respective bandgaps higher than the bandgap of the carrier generating region, the respective bandgaps being transparent to the light of the given wavelength, the n-doped semiconductor region and the p-doped semiconductor region being along different sides of the carrier generating region; and an interface region between the carrier generating region and a given doped region of the n-doped semiconductor region or the p-doped semiconductor region, the interface region comprising one or more of a semiconductor alloy and a semiconductor sequence that is one or more of graded and stepped in composition, selected to reduce a band offset between the carrier generating region and the given doped region adjacent the interface region.

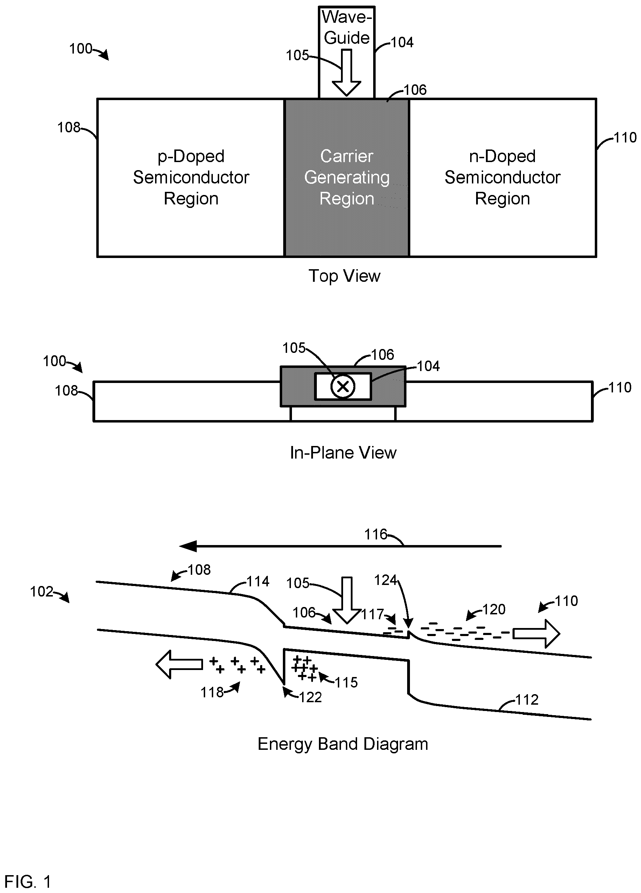

Attention is next directed to FIG. 1, which depicts a prior art photodiode 100 and in particular (as labeled) a top view, an in-plane view, and an energy band diagram 102 of the prior art photodiode 100. For example, the top view shows the prior art photodiode 100 with an input waveguide 104 (e.g., interchangeably referred to herein as the waveguide 104), which may provide modulated light 105 to a carrier generating region 106 of the prior art photodiode 100, and such modulated light 105 may have a signal encoded therein, that may be converted to a modulated signal and/or current by the carrier generating region 106. The waveguide 104 may be an end of a longer waveguide (not depicted), and/or the waveguide 104 may be in optical communication with such a longer waveguide. Regardless, in use, the waveguide 104 may be in optical communication with a transmitter of an optical communication system, that is transmitting data to the photodiode 100 in the form of the modulated light 105 that is input to the carrier generating region 106. The photodiode 100 may be a component of a receiver (e.g., a PIC receiver) in such an optical communication system.

The photodiode 100 further comprises contacts and in particular, as depicted, a p-doped semiconductor region 108 and an n-doped semiconductor region 110 for receiving current generated by the carrier generating region 106. As depicted, in both the top view and the in-plane view, the doped semiconductor regions 108, 110 are located on opposite sides of the carrier generating region 106, though other architectures are possible.

As transmitted light provided by the waveguide 104 is understood to be modulated, the current generated by the carrier generating region 106 may also be modulated, such that the data encoded in the transmitted light provided by the waveguide 104 is determined from other components (not depicted) that receive the modulated current.

Indeed, as best seen in the in-plane view, which depicts the photodiode 100 from a direction of the waveguide 104 and/or the modulated light 105 (depicted as a circle with cross inside to indicate the modulated light 105 is going "into" the page of the in-plane view), the carrier generating region 106 may be fabricated by etching a cavity in a semiconductor that forms both the doped semiconductor regions 108, 110, depositing a semiconductor of the carrier generating region 106 into the cavity, and using implantation techniques to respectively p-dope and n-dope the doped semiconductor regions 108, 110. As best seen in the in-plane view, a portion of the semiconductor may remain "under" the semiconductor of the carrier generating region 106 as a "bottom" of the cavity.

Attention is next directed to the energy band diagram 102, which depicts the valence bands 112 and the conduction bands 114 of the regions 106, 108, 110. It is understood that the bands 112, 114 are depicted in the presence of an electric field 116 (e.g., a reverse bias electric field) between the doped regions 108, 110 (e.g., from the n-doped semiconductor region 110 to the p-doped semiconductor region 108). As such, the bands 112, 114 are sloped. It is furthermore understood that the bands 112, 114 are not drawn to scale, but show general trends thereof.

As also depicted at the energy band diagram 102, as the modulated light 105 from the waveguide 104 is absorbed by the carrier generating region 106, holes 115 and electrons 117 are generated, respectively represented in FIG. 1, as plus signs ("+") and negative signs ("-"). This convention will be used throughout the present specification. The holes 115 are understood to be generated in the valence band 112 of the carrier generating region 106, and the electrons 117 are understood to be generated in the conduction band 114 of the carrier generating region 106 (e.g., as the electrons 117 are excited by the modulated light 105, when the modulated light 105 is absorbed by the of the carrier generating region 106, the electrons 117 jump from the valence band 112 to the conduction band 114, forming the holes 115 in the valence band 112). The holes 115 and electrons 117 may, together, be referred to as carriers 115, 117. The holes 115 and the electrons 117 are separated by the applied electric field 116 and flow to respective sides of the carrier-generating region 106. At the sides of the carrier-generating region, the holes 115 encounter a barrier represented by a band offset 122, and the electrons 117 encounter a barrier represented by a band offset 124.

Once the carriers 115, 117 have exited the carrier generating region 106, a photocurrent is formed by the respective flow of holes 118 and electrons 120 outside of the carrier generating region 106. Put another way, as depicted, the holes 115 and the electrons 117 are inside the carrier generating region 106, and the holes 118 and the electrons 120 are outside the carrier generating region 106 and form a photocurrent. However, it is understood that the holes 118 outside the carrier generating region 106 represent flow of the holes 115 inside the carrier generating region 106 past the barrier represented by the band offset 122, and the electrons 120 outside the carrier generating region 106 represent flow of the electrons 115 inside the carrier generating region 106 past the barrier by the band offset 122. Furthermore, as indicated by respective adjacent arrows, the holes 115 flow to the p-doped semiconductor region 108 via the valence band 112, and the electrons 117 flow to the n-doped semiconductor region 110 via the conduction band 114, at least partially due to the electric field 116.

In a particular example, a semiconductor of the carrier generating region 106 may comprise germanium, and in particular intrinsic (e.g., undoped) germanium, and a semiconductor of both of the doped regions 108, 110 may comprise silicon, such that the photodiode 100 comprises a Si-Ge-Si heterostructure photodiode with abrupt interfaces in which a partially etched Si region forms a silicon cavity within which intrinsic germanium is deposited (e.g., and with reference to the in-plane view, silicon may remain "under" the germanium as indicated by the portion of the semiconductor "under" the carrier generating region 106).

However, any suitable semiconductors may be used for each of the regions 106, 108, 110, as long as the respective bandgaps meet the conditions referred to herein. Another restriction may be that, for deposition and general stability, such semiconductors may have similar lattice constants and/or generally matched lattice constants.

Furthermore, while herein the doped regions 108, 110 are described comprising the same semiconductor, such as silicon, the doped regions 108, 110 may comprise any suitable semiconductors including the doped regions 108, 110 comprising a same semiconductor, though differently doped, or different semiconductors.

In general, a semiconductor of the carrier generating region 106 may be selected such that a bandgap between the valence band 112 and the conduction band 114 absorbs the modulated light 105, which is understood to have a given wavelength, which may be compatible with an optical communication system. In a particular example, a given wavelength of the modulated light 105 may be 1310 nm, and/or about 1310 nm, which is a typical wavelength used in optical communication systems, though other wavelengths are within the scope of the present specification.

Similarly, semiconductors of the regions 108, 110 may be selected such that a bandgap between the valence band 112 and the conduction band 114 is transparent to the modulated light 105, of the given wavelength.

Indeed, a general requirement of photodiodes is that bandgaps of carrier generating regions, such as the carrier generating region 106, be smaller than respective energy of light that the carrier generating regions are to absorb. In the case of 1310 nm, having an energy of about 0.95 eV, intrinsic germanium generally meets this requirement, having a bandgap of about 0.66 eV at room temperature (e.g., 300 K or 27° C to allow for some heating of photodiodes incorporated into PICs). Furthermore, semiconductor materials with lower bandgap energies generally have higher optical refractive indices.

Similarly, a general characteristic of photoconductor structures, at least in PIC waveguides, is that the contact regions, such as the doped regions 108, 110, have a lower optical refractive index and a respective bandgap energy that is larger than the photon energy of the light 105, so that the contact regions are generally transparent to the light. Such a characteristic may ensure that absorption of light is minimized in the contact regions and/or such a characteristic may ensure that carrier generation and/or current generation is localized at a carrier generating region. In the case of 1310 nm, silicon generally meets this requirement, having a bandgap of about 1.12 eV at room temperature (e.g., 300 K or 27° C to allow for some heating of photodiodes incorporated into PICs).

As such, as seen in the energy band diagram 102, there is a discontinuity in the respective valence bands 112 and the respective conduction bands 114 of the carrier generating region 106 and the doped regions 108, 110. Depending on the semiconductors used in the regions 106, 108, 110, the band discontinuity, which may also be referred to as a band offset, may be larger or smaller. Furthermore, such a band offset may be different between the carrier generating region 106 and each of the doped regions 108, 110, and furthermore, a band offset may be respectively different for the regions 112, 114.

Returning to the energy band diagram 102, and using germanium and silicon as example respective materials for the carrier generating region 106 and the doped regions 108, 110, due to the abrupt interface therebetween, a band offset 122 in the valence band 112 between the carrier generating region 106 and the p-doped semiconductor region 108 is relatively high, for example as compared to a band offset represented by the barrier 124 in the conduction band 114 between the carrier generating region 106 and the n-doped semiconductor region 110. This leads to carrier screening and the other effects referred to herein.

Indeed, the barrier due to the band offset 122 for the holes 115 may be more problematic than the barrier due to the band offset 124 for the electrons 117 because the band offset fraction between germanium and silicon is generally skewed toward the valence band 112 (e.g., more of the difference in bandgaps occurs for the valence band 112 than for the conduction band 114). In addition, the holes 115 are generally heavier than the electrons 117, and hence it is less likely for the holes 117 to be thermally excited over the barrier due to the band offset 122.

A build-up of the holes 115 at the barrier due to the band offset 122 (and, to a lesser extent, a build-up of the electrons 117 at the barrier due to the band offset 124) is what leads to the carrier screening, not the existence of the band offset s 122, 124 themselves. For example, at low levels of the light, the barriers due to the band offset s 122, 124 would still exist, but there wouldn't be enough carriers 115, 117 to significantly screen the electric-field 116.

Regardless, under normal operating conditions and/or normal intensities of the light 105, , the holes 115, 118 and the electrons 117, 120 may generally form an electric field in opposition to the applied electric field 116 due to carrier screening (e.g., the holes 118 and the electrons 120 that form the photocurrent may contribute the carrier screening), that may reduce current, overall responsivity and linearity of the photodiode 100. Furthermore, while the applied electric field 116 may be generally increased to provide the holes 115 with enough energy to overcome the band offset 122, the band offset 122 still remains. The band offset 122 thus leads to overall degradation of the performance of the photodiode 100.

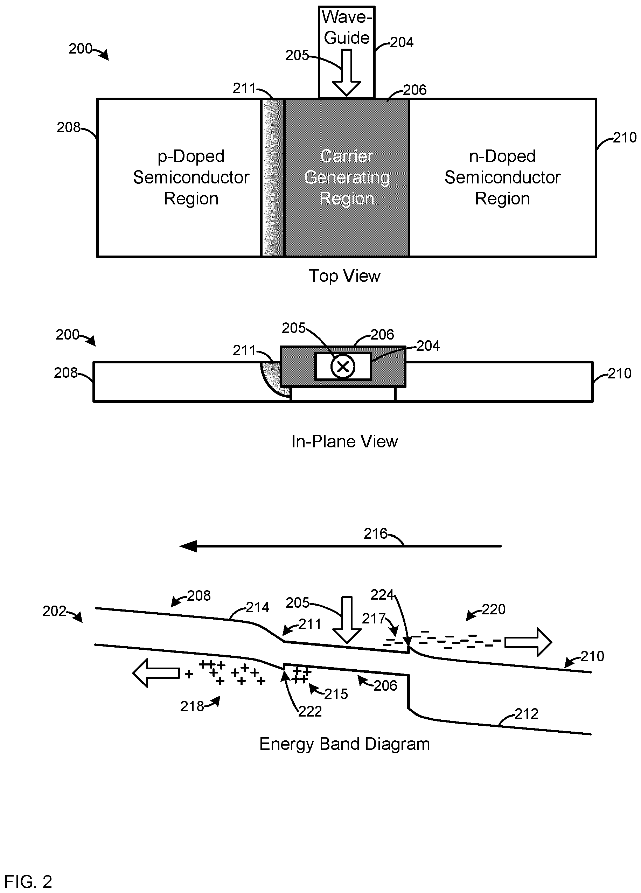

Attention is next directed to FIG. 2, which depicts a photodiode 200 that addresses the technical challenges of the prior art photodiode 100. In particular, FIG. 2 depicts a top view, an in-plane view, and an energy band diagram 202 of the photodiode 200. Indeed, the photodiode 200 represents a modified version of the prior art photodiode 100, with like components having like numbers, but in a "200" series rather than a "100" series.

Hence, for example, the photodiode 200 is depicted with an input waveguide 204 (e.g., interchangeably referred to herein as the waveguide 204) providing modulated light 205 to a carrier generating region 206 of the photodiode 200, and the photodiode 200 comprises the carrier generating region 206, a p-doped semiconductor region 208 and an n-doped semiconductor region 210, that act as contacts to the carrier generating region 206. However, in contrast to the prior art photodiode 100, the photodiode 200 further comprises an interface region 211 between the carrier generating region 206 and a given doped region, for example, as depicted, the p-doped semiconductor region 208. In general, the interface region 211 comprises one or more of a semiconductor alloy and a semiconductor sequence, that is one or more of graded and stepped in composition, selected to reduce a band offset between the carrier generating region 206 and the given doped region adjacent the interface region 211.

The depicted example assumes that the carrier generating region 206 comprises germanium, and the doped regions 208, 210 comprise silicon, that are respectively, and accordingly, doped, and hence would have an energy band diagram similar to the energy band diagram 102 of the prior art photodiode 100 without the interface region 211.

However, due to the interface region 211 being located between the carrier generating region 206 and the p-doped semiconductor region 208, the energy band diagram 202 of the photodiode 200 is modified compared to the energy band diagram 102 of the photodiode 100 as is next described.

In particular, the energy band diagram 202 depicts the valence bands 212 and the conduction bands 214 of the regions 206, 208, 210, 211. It is understood that the bands 212, 214 are depicted in the presence of an electric field 216 (e.g., a reverse biased electric field) between the doped regions 208, 210 (e.g., from the n-doped semiconductor region 210 to the p-doped semiconductor region 208). As such, the bands 212, 214 are sloped. It is furthermore understood that the bands 212, 214 are not drawn to scale, but show general trends thereof.

As also depicted at the energy band diagram 202, as the modulated light 205 from the waveguide 204 is absorbed by the carrier generating region 206, holes 215 and electrons 217 are generated. The holes 215 are understood to be formed in the valence band 212 of the carrier generating region 206, and the electrons 217 are understood to be formed in the conduction band 214 of the carrier generating region 206 (e.g., as the electrons 217 are excited by the modulated light 205, when the modulated light 205 is absorbed by the of the carrier generating region 206, the electrons 220 jump from the valence band 212 to the conduction band 214, forming the holes 215 in the valence band 212). Hereafter, a similar convention will be used to refer to holes 215 and electrons 217 in the carrier generating region 206, and holes 218 and electrons 218 in the p-doped semiconductor region 208 and the n-doped semiconductor region 210.

In particular the holes 218 and electrons 220 that flow past respective band offsets 222, 224 are understood to form the photocurrent generated by the carrier generating region 206. Furthermore, as indicated by respective adjacent arrows, the holes 215 flow to the p-doped semiconductor region 208 via the valence band 212, and the electrons 217 flow to the n-doped semiconductor region 210 via the conduction band 214, at least partially due to the electric field 216.

Continuing with the example of a semiconductor of the carrier generating region 206 comprising germanium, and in particular intrinsic (e.g., undoped) germanium, and a semiconductor of both of the doped regions 208, 210 comprising silicon, the photodiode 200 may comprise a Si-Ge-Si heterostructure photodiode, which may be formed in a manner similar to the photodiode 100.

However, any suitable semiconductors may be used for each of the regions 206, 208. As such, while the example of FIG. 2 is described with reference to the interface region 211 being between the carrier generating region 206 and the p-doped semiconductor region 208, in other examples, an interface region may be provided between the carrier generating region 206 and the n-doped semiconductor region 210, depending on the materials thereof.

In contrast to the photodiode 100, the photodiode 200 further comprises the interface region 211, which may be fabricated by growing and/or forming the interface region 211 between the carrier generating region 206 and the p-doped semiconductor region 208 in any suitable manner.

The interface region 211 generally reduces a band offset between the carrier generating region 106 and a given doped region adjacent the interface region 211, for example, as depicted, the p-doped semiconductor region 208.

As depicted in FIG. 2, the interface region 211 may comprise a graded alloy of the semiconductor of the carrier generating region 206 and the respective semiconductor of the p-doped semiconductor region 208. For example, again using the germanium and silicon as examples, semiconductor content of the interface region 211 may be represented as Si₁₋ₓGeₓ:p, where "x" represents the fraction of germanium in the graded semiconductor region 211 (e.g., substituting p-doped germanium for p-doped silicon). In particular, at an interface between the p-doped semiconductor region 208 and the interface region 211, the semiconductor content of the interface region 211 is a combination of p-doped silicon, and p-doped germanium that is higher in silicon content than germanium content (e.g. "1-x" is higher than "x" in Si₁₋ₓGeₓ:p), and at an interface between the carrier generating region 206 and the interface region 211, the semiconductor content of the interface region 211 is a combination of p-doped silicon, and p-doped germanium that is higher in germanium content than silicon content (e.g. "x" is higher than "1-x" in Si₁₋ₓGeₓ:p). For example, interface region 211 may comprise a graded alloy of silicon and germanium that increases in germanium content, and decreases in silicon content, from the p-doped semiconductor region 208 to the carrier-generating region 206. The entirety of the interface region 211 may be p-doped (e.g., when p-doping the silicon of the p-doped semiconductor region 208) using implantation techniques, and the like. Furthermore, as best seen in the in-plane view, the interface region 211 may not be layer of uniform thickness "in-plane", but rather may be fabricated in any suitable manner (e.g., using ion implantation and/or diffusion into a selected area and/or crystal growth and/or which may be accomplished with sequential addition of material with different desired compositions using, as option, silicon oxide or silicon nitride masks for selective chemical vapor growth and then, as option, partial removal to build up region 211), as long as the interface region 211 is between respective portions of the regions 206, 208 where the holes 218 flow from the carrier generating region 206 to the p-doped semiconductor region 208.

A width of the interface region 211 may be any suitable value, but may be between about 5% and about 50% of a width of the carrier generating region 206, though such a width of the interface region 211 may depend on a process used to fabricate the photodiode 100 and/or may be relatively independent of a width of the carrier generating region 206; for example, using crystal growth, a width of the interface region 211 may be in a range of about 0.1 µm to about 0.3 µm, though any suitable widths are within the scope of the present specification. Furthermore, using germanium as an example of a material of the carrier generating region 206, in a waveguide-coupled PIC, a width of the carrier generating region 206 (e.g. between the regions 208, 210) may be in a range of about 0.4 µm to about 1 µm, though any suitable widths are within the scope of the present specification; furthermore, the width of the interface region 211 may be adjusted accordingly. Furthermore, the width of the carrier generating region 206 may depend on a material thereof and/or a process for fabrication thereof; hence, other suitable widths may occur to persons of skill in the art that are within the scope of the present specification.

Similarly, "x" may change linearly with distance from the p-doped semiconductor region 208, however, "x" may change in any suitable manner, including but not limited to, changing parabolically with distance from the p-doped semiconductor region 208, amongst other possibilities.

Similarly, a width and/or change in semiconductor content in the interface region 211 may be heuristically selected to reduce a band offset 222 between the carrier generating region 206 and the p-doped semiconductor region 208, as is next described, for example relative to a band offset 122 of the prior art photodiode 100. In particular, such heuristic selection may be to control the band offset 222, for example by heuristically selecting width and/or change in semiconductor content in the interface region 211.

For example, with reference to the energy band diagram 202, there is a discontinuity in the respective valence bands 212 and the respective conduction bands 214 of the carrier generating region 206 and the doped regions 208, 210. For example, as clearly seen in the energy band diagram 202, the band offset 222 between the carrier generating region 206 and the p-doped semiconductor region 208 is smaller than the corresponding band offset 122 of the prior art photodiode 100, due to the presence of the interface region 211.

In particular, due to the semiconductor alloy grading of the interface region 211, and/or due to the semiconductor content of the interface region 211, adjacent the carrier generating region 206, being a graded alloy that includes the same semiconductor as the carrier generating region 206, (e.g., though such a semiconductor may be p-doped and/or extrinsic and/or undoped and/or intrinsic in the interface region 211), the band offset 222 is reduced relative to the band offset 122.

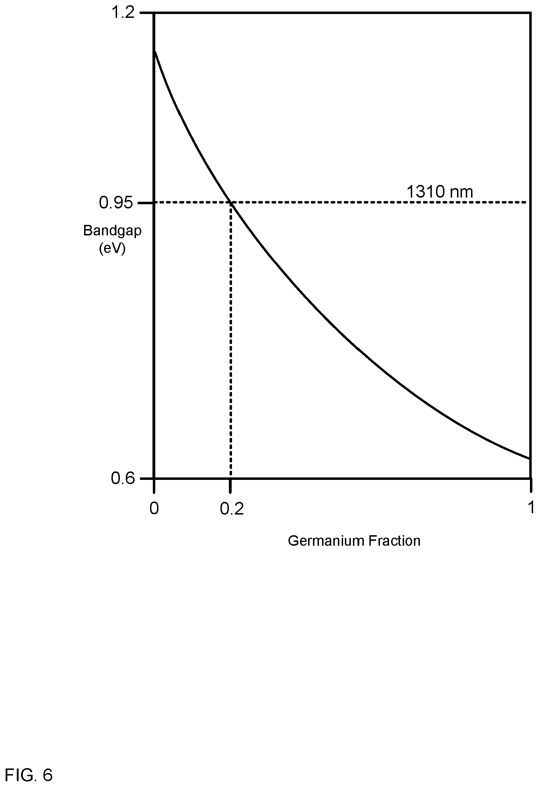

Furthermore, the semiconductor content grading of the interface region 211 may be selected such that the bandgap of the interface region 211 renders the interface region 211 transparent to the modulated light 205. For example, attention is next directed to FIG. 6, which depicts the bandgap, in eV, of germanium/silicon alloys as a function of germanium fraction ranging from "0" to "1", for example at 300K (e.g., and which may be determined from Vegard's Law and/or heuristically). Furthermore, an energy of 0.95 eV of light of 1310 nm is depicted. It is understood that above 0.95 eV, a corresponding bandgap is transparent to light of 1310 nm and below 0.95 eV, a corresponding bandgap absorbs light of 1310 nm. It is further understood from FIG. 6 that below a germanium fraction of 0.2 (e.g., the fraction at which the bandgap is 0.95 eV), alloys of silicon and germanium absorb light of 1310 nm. Hence, returning to FIG. 2, the graded alloy of the interface region 211 may have a germanium content of less than 0.2, for example of about 0.195 adjacent the carrier generating region 206, or any other suitable fraction, and may change linearly from the carrier generating region 206 to the p-doped semiconductor region 208 to a germanium content of 0.0, or any other suitable fraction. Indeed, the graph of FIG. 6, may be used to select the bandgap of the graded alloy of the interface region 211, adjacent the carrier generating region 206 to be as small as possible, but still be transparent to light of 1310 nm.

Put another way, like the p-doped semiconductor region 208, the interface region 211 is transparent to the modulated light 205 of the given wavelength, and furthermore the interface region 211 may form part of the p-doped semiconductor region 208, as described in more detail below. Put yet another way, a bandgap of the interface region 211, which increases from the carrier generation region 206 to the p-doped semiconductor region 208 (e.g., and/or increases with decreasing "x"), may be transparent to the modulated light 205 of the given wavelength.

Furthermore, a step in the valence band 212 due to the band offset 222 is depicted, and which is reduced relative to the band offset 122.

As such, relative to the prior art photodiode 100, the holes 215 have a smaller energy barrier (e.g., represented by the band offset 222) to overcome. For example, the carrier pileup of holes 215 is reduced in the carrier generating region 206 (e.g. at the valence band side) leading to the p-doped semiconductor region 208 and carrier screening is reduced. In other implementations, a corresponding interface region may be introduced to reduce the barrier due to the band offset 224, that may reduce a carrier pileup of electrons 217 in the carrier generating region 206 at the conduction band side leading to the n-doped semiconductor region 210, as described below.

It is further understood that while the regions 206, 208, 210, 211 have been described with respect to germanium and silicon, the regions 206, 208, 210, 211 may comprise any suitable respective semiconductors. Furthermore, while herein the doped regions 208, 210 are described comprising the same semiconductor, such as silicon, the doped regions 208, 210 comprising any suitable different semiconductors.

Furthermore, while the interface region 211 is depicted in FIG. 2 as being between the carrier generating region 206 and the p-doped semiconductor region 208, in other examples, which may depend on the semiconductors used to fabricate the photodiode 200, the interface region 211 may be between the carrier generating region 206 and the n-doped semiconductor region 210.

Furthermore, in the example of FIG. 2, a band offset 224 in the conduction band 214 between the carrier generating region 206 and the n-doped semiconductor region 210, formed by the abrupt physical interface between the carrier generating region 206 and the n-doped semiconductor region 210, is small enough for the electrons 220 to flow from the carrier generating region 206 to the n-doped semiconductor region 210 without carrier screening being an issue. However, such a band offset 224, which is similar to, and/or the same as, the band offset 124, may be due to the semiconductors of the photodiode 200 being germanium and silicon. When other semiconductors are used, the band offset 224 may be similar to the band offset 122, and/or large enough for carrier screening to be an issue, and hence a respective interface region may be provided between the carrier generating region 206 and the n-doped semiconductor region 210. Indeed, a respective interface region may be provided between the carrier generating region 206 and one, or both, of the doped regions 208, 210, to reduce respective band offset s between the carrier generating region 206 and the p-doped semiconductor region 208 (e.g., in the valence band 212), and/or between the carrier generating region 206 and the n-doped semiconductor region 210 (e.g., in the conduction band 214).

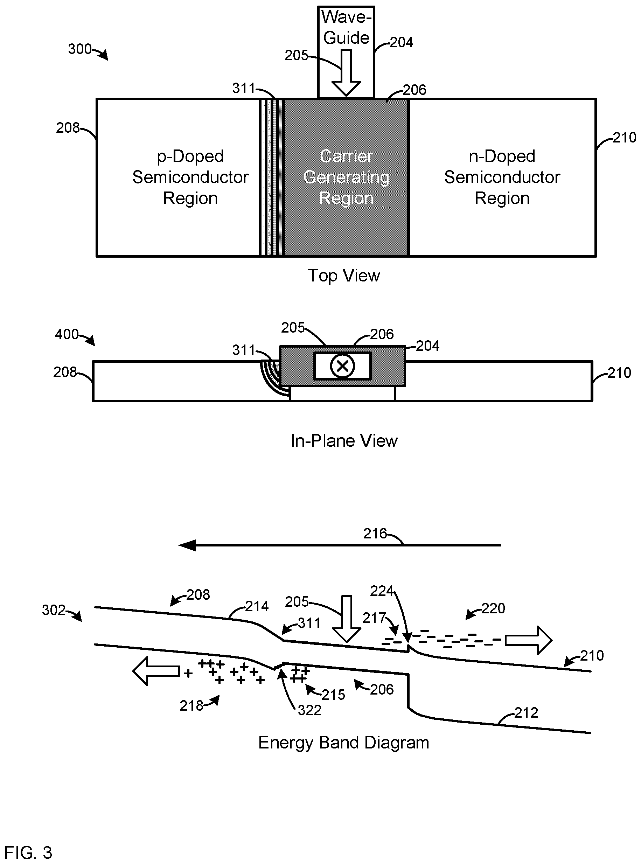

Furthermore, while the example of FIG. 2 is described with respect to the interface region 211 comprising a graded alloy of respective semiconductors of the carrier generating region 206 and the p-doped semiconductor region 208, in other examples, an interface region may be provided comprising a semiconductor sequence that is stepped in composition, as is next described with respect to FIG. 3.

In particular FIG. 3 depicts a photodiode 300 that is similar to the photodiode 200, with like components having like numbers, except where indicated herein. In particular, FIG. 2 depicts a top view, an in-plane view, and an energy band diagram 302 of the photodiode 300.

In comparison to the photodiode 200, the photodiode 300 also comprises an interface region 311, located between the carrier generating region 206 and the p-doped semiconductor region 208, comprising a semiconductor sequence that is stepped in composition. For example, as depicted, the interface region 311 comprises four layers, and again using germanium and silicon as an example, a semiconductor content of the interface region 311 may be represented as Si₁₋ₓₙGeₓₙ:p, wherein "x" represents the fraction of germanium in a layer "n" of the stepped interface region 311, and hence "n" is one of 1, 2, 3 and 4, with "n=1" indicating a first layer with composition x = x1 of the interface region 311 closest to the p-doped semiconductor region 208, and "n=4" indicating a last layer with composition x = x4 of the interface region 311 closest to the carrier generating region 206. In general, as "n" increases, a fraction "(1-x)" of p-doped silicon content of the stepped interface region 311 decreases and a fraction "x" of p-doped germanium content of the stepped interface region 311 increases. Again, the respective content of the various layers may be selected using the graph of FIG. 6, similar as described above with respect to the photodiode 200, and with similar conditions applying.

Put another way, the change in semiconductor content from layer to layer of the interface region 311 may be similar to the change in semiconductor content of the graded alloy of the interface region 211, but provided in a stepped configuration, rather than a graded configuration.

Furthermore, while four steps are depicted, the interface region 311 may be provided with any suitable number of steps.

Attention is next directed to the energy band diagram 302, and in particular to the band offset 322 that has been modified, relative to the band offset 222, due to the stepped configuration of the interface region 311.

Again, the semiconductor content of the interface region 311 may be selected such that the bandgap renders the interface region 311 generally transparent to the modulated light 205. Put another way, like the p-doped semiconductor region 208, the interface region 311 may be generally transparent to the modulated light 205 of the given wavelength. Put yet another way, a bandgap of the interface region 311, which increases from the carrier generation region 206 to the p-doped semiconductor region 208 (e.g., and/or decreases the p-doped semiconductor region 208 to the carrier generation region 206), may be generally transparent to the modulated light 205 of the given wavelength.

Furthermore, the band offset 322 is provided in steps corresponding to the steps of the interface region 311. The steps of the band offset 322 of the photodiode 200, may be equivalent to the band offset 222 of the photodiode 200. Put another way, the effect of the stepped interface region 311 is similar to the effect of the graded interface region 211 in reducing the band offset and in reducing carrier pileup or trapping and carrier screening.

It is further understood that aspects of the interface regions 211, 311 may be combined. For example, one or more steps of the interface region 311 may be graded similar to the interface region 211, whereas one or more other steps of the interface region 311 may not be graded.

Furthermore, the steps of the interface region 311 may be provided as alternating layers of germanium and silicon, again with germanium content decreasing the closer to the p-doped semiconductor region 208, and silicon content increasing the closer to the p-doped semiconductor region 208. In this example, the layers are selected so that an average bandgap increases over the interface region 311, from the carrier generating region 206 to the p-doped semiconductor region 208, similar to as depicted in FIG. 3 (and/or FIG. 2).

Hence, provided herein is a photodiode comprising: a carrier generating region comprising a semiconductor having a bandgap that absorbs light of a given wavelength, such that electrical charge carriers are generated in the carrier generating region by the light of the given wavelength; an n-doped semiconductor region and a p-doped semiconductor region having respective bandgaps higher than the bandgap of the carrier generating region, the respective bandgaps being transparent to the light of the given wavelength, the n-doped semiconductor region and the p-doped semiconductor region being along different sides of the carrier generating region; and an interface region between the carrier generating region and a given doped region of the n-doped semiconductor region or the p-doped semiconductor region, the interface region comprising one or more of a semiconductor alloy and a semiconductor sequence that is one or more of graded and stepped in composition, selected to reduce a band offset between the carrier generating region and the given doped region adjacent the interface region.

Furthermore, the semiconductor of the carrier generating region may comprise a carrier-generating and/or absorbing semiconductor (e.g. absorbing of wavelengths of the incident light 205) and the given doped region may comprise a transparent semiconductor different from the carrier-generating and/or absorbing semiconductor (e.g. generally transparent to wavelengths of the incident light 205), and the interface region may comprise a graded alloy of the carrier-generating and/or absorbing semiconductor and the transparent semiconductor, and, in the interface region, content of the carrier-generating and/or absorbing semiconductor in the graded alloy may decrease from the carrier generating region to the given doped region, and respective content of the doped semiconductor in the graded alloy may increase from the carrier generating region to the given doped region.

Hence, herein, semiconductor of a carrier generating region is understood to generate carriers for example by absorbing incident light. While intrinsic germanium is used as one example of such a semiconductor, such a semiconductor may not be intrinsic and indeed even germanium may be (e.g., lightly doped), as long as the germanium generates carriers by absorbing incident light. Hence, a semiconductor of a carrier generating region may be referred to, interchangeably, as a carrier-generating semiconductor and/or an absorbing semiconductor and/or a carrier-generating absorbing semiconductor, and the like.

Similarly, herein, a given doped region is understood to be generally transparent to the light absorbed by the semiconductor of the carrier generating region to for the given doped region acts as a contact. Hence, a semiconductor of a given doped region may be referred to, interchangeably, as a transparent semiconductor and/or a contact semiconductor, and/or a transparent contact semiconductor and the like.

Alternatively, or in addition, the semiconductor of the carrier generating region may comprise a carrier-generating and/or absorbing semiconductor and the given doped region may comprise a transparent semiconductor different from the carrier-generating and/or absorbing semiconductor, and in the interface region, content of the carrier-generating and/or absorbing semiconductor in the steps decreases from the carrier generating region to the given doped region, and respective content of the transparent semiconductor in the steps increases from the carrier generating region to the given doped region.

More generally, the semiconductor of the carrier generating region may comprise a carrier-generating and/or absorbing semiconductor and the given doped region may comprise a transparent semiconductor different from the carrier-generating and/or absorbing semiconductor, and the interface region may comprise at least one step in respective content of the carrier-generating and/or absorbing semiconductor and the transparent semiconductor.

Put another way, and with reference to specific example shown in FIG. 3, while the interface region 311 was described with respect to four steps and/or layers, the interface region 311 may comprise as few as one step and/or one layer, having a semiconductor content that is a mixture of the intrinsic semiconductor of the carrier generating region 206 and the p-doped semiconductor of the p-doped semiconductor region 208, as long as the reduction in band offset is achieved.

Furthermore, and more generally, and with reference to the band offset 222 and/or the band offset 322, the interface region 211, 311 may provide one or more band offset steps in the band offset between the carrier generating region 206, and a given doped region, such as the p-doped semiconductor region 208.

Furthermore, the semiconductor of the carrier generating region 206 may comprise intrinsic germanium, and the given doped region may comprise the p-doped semiconductor region 208, and the p-doped semiconductor region 208 may comprise p-doped silicon.

Indeed, an interface region provided herein may be between a carrier generating region and a p-doped semiconductor region, such that carriers for which the band offset is reduced comprise holes.

However, the interface region provided herein may be a carrier generating region and an n-doped semiconductor region, such that carriers for which the band offset is reduced comprise electrons.

As depicted in FIG. 2 and FIG. 3 is understood that the interface regions 211, 311 may be formed from a portion of a given doped region, as depicted the p-doped semiconductor region 208, closest to the carrier generating region 206. Put another way, the interface regions 211, 311 may be formed during formation of at least a portion of the p-doped semiconductor region 208, for example at least in conjunction with p-doping the p-doped semiconductor region 208 and the interface regions 211, 311.

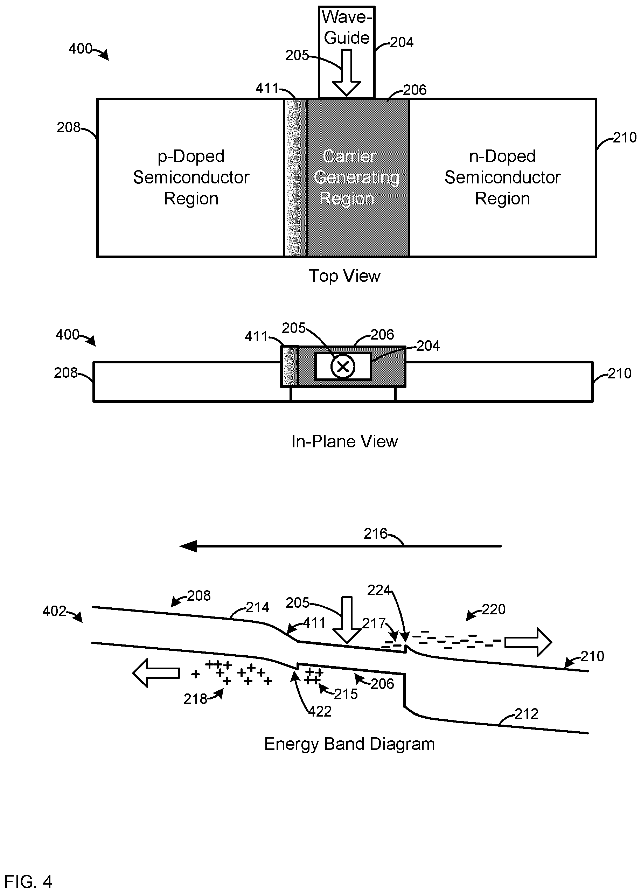

However, in other examples, interface regions may be formed as a portion of a carrier generating region. For example, attention is next directed to FIG. 4, which is substantially similar to FIG. 2, with like components having like numbers.

In particular FIG. 4 depicts a photodiode 400 that is similar to the photodiode 200, with like components having like numbers, except where indicated herein. In particular, FIG. 4 depicts a top view, an in-plane view, and an energy band diagram 402 of the photodiode 400.

However, at the photodiode 400, an interface region 411, which may comprise a graded alloy (e.g., as depicted), similar to the interface region 211, and/or a semiconductor sequence that is stepped in composition, similar to the interface region 311, may be incorporated into a portion of the carrier generating region 206, for example, as depicted, that is closest to the p-doped semiconductor region 208 (e.g., again using germanium and silicon as examples).

As in the depicted example, the interface region 411 comprises a graded alloy, the energy band diagram 402 is similar to the energy band diagram 202, but with a band offset 422 shifted towards the carrier generating region 206 relative to the band offset 322 of the energy band diagram 302. When the interface region 411 comprises a semiconductor sequence, similar to the interface region 311, the energy band diagram 402 may be similar to the energy band diagram 302, with a stepped band offset and sloped regions shifted towards the carrier generating region 206.

Furthermore, again using the germanium and silicon as examples, semiconductor content of the interface region 411 may be represented as Si₁₋ₓGeₓ:p, similar to the interface region 211, which assumes the semiconductors of the interface region 411 are p-doped.

Alternatively, and again using the germanium and silicon as examples, semiconductor content of the interface region 411 may be represented as Si₁₋ₓGeₓ:i, when silicon and germanium of the interface region 411 are intrinsic (e.g., as indicated by "i"), though "x" may change similar to as described herein with respect to the interface region 211.

The examples of FIG. 2, FIG. 3 and FIG. 4, show an n-doped semiconductor region and a p-doped semiconductor region on opposite sides of a carrier generating region, with an interface region between the carrier generating region and the p-doped semiconductor region, though such an interface region may be between the carrier generating region and the n-doped semiconductor region.

However, other architectures are within the scope of the present specification.

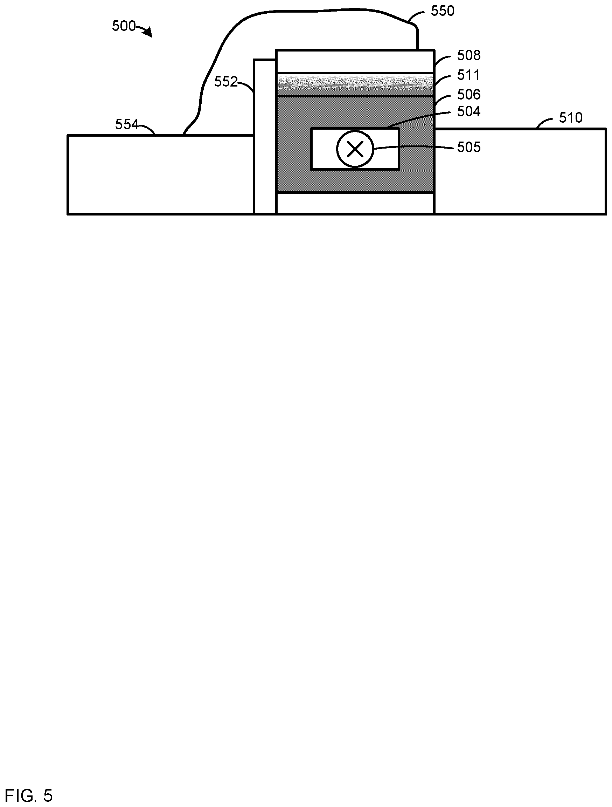

For example, attention is next directed to FIG. 5, which depicts an in-plane view of a photodiode 500, with a stacked architecture, as is next described.

The photodiode 500 is further depicted with an input waveguide 504 (e.g., interchangeably referred to herein as the waveguide 504) providing modulated light 505 to a carrier generating region 506 of the photodiode 500, and the photodiode 500 comprises the carrier generating region 506, a p-doped semiconductor region 508 and an n-doped semiconductor region 510, that act as contacts to the carrier generating region 506. The photodiode 500 further comprises an interface region 511 between the carrier generating region 506 and the p-doped semiconductor region 508. The interface region 511 may be similar to any of the interface regions 211, 311, 411, and the like. Furthermore, alternatively, or in addition, the photodiode 500 may include an interface region between the carrier generating region 506 and the n-doped semiconductor region 510.

However, in contrast to the photodiodes 200, 300, 400, the photodiode 500 has stacked architecture, in which the interface region 511 is grown the carrier generating region 506, for example on a side of the carrier generating region 506 adjacent a side of the carrier generating region 506 at which the n-doped semiconductor region 510 is located. Furthermore, the p-doped semiconductor region 508 is grown on the interface region 511. However, it is understood that the interface region 511 and the p-doped semiconductor region 508 are fabricated so that the interface region 511 and the p-doped semiconductor region 508 do not contact and/or short to the n-doped semiconductor region 510. Put another way, the n-doped semiconductor region 510 extends along only a portion of a side of the carrier generating region 506, and ends prior to an adjacent side of the carrier generating region 506 where the interface region 511 is located.

In addition, the photodiode 500 further comprises conductive regions 550, 554 in electrical communication with the p-doped semiconductor region 508, to conduct holes generated by the carrier generating region 506 to a side of the carrier generating region 506 that is opposite the n-doped semiconductor region 510. In this example, an insulating region 552 is provided that extends from the conductive region 550 and along the regions 506, 508, 511 and is furthermore between a portion of the conductive region 550 that is along a side of the regions 506, 511 (e.g. and a portion of the p-doped semiconductor region 508) , and furthermore between the conductive region 554 and, as depicted, at least the carrier generating region 506.

The insulating region 552 generally prevents contact and/or shorts between the conductive regions 550, 554 to and sides of regions 506, 511.

The conductive regions 550, 554 are provided merely to ensure that current generated by the carrier generating region 506 may be accessed from opposite sides of the photodiode 500. The conductive region 550 may comprise a conductive epoxy or a conductive metal or wire-bond, and the conductive region 554 may comprise silicon. Similarly, the insulating region 552 may comprise any suitable material, such as silicon oxide, and the like, though a material of the insulating region 522 may depend on a material of a substrate on which the photodiode 500 is formed.

Furthermore, while an energy band diagram of the photodiode 500 is not depicted, the energy band diagram of the photodiode 500 may be similar to any of the energy band diagrams 202, 302 depending on whether the interface region 511 is graded and/or stepped, and assuming a reverse bias electric field is applied to the photodiode 500.

The example of FIG. 5 hence shows an n-doped semiconductor region and a p-doped semiconductor region on adjacent sides of a carrier generating region, with an interface region between the carrier generating region and the p-doped semiconductor region, though such an interface region may be between the carrier generating region and the n-doped semiconductor region.

While present examples of the photodiodes 200, 300, 400, 500 are described with respect to silicon and germanium, other materials are within the scope of the present specification. For example, one or more of the photodiodes 200, 300, 400, 500 may be adapted to include suitable combinations of InGaAs (indium gallium arsenide) and InP (indium phosphide). For example, one or more of the photodiodes 200, 300, 400, 500 may include an absorbing layer (e.g., a carrier generation layer 206, 506) comprising InGaAs (e.g. of any suitable relative content of indium and gallium), contact layers of suitably doped InP (e.g., regions 208, 210 and/or regions 508, 510), and graded and/or stepped interface regions of Ga₁₋ₓInₓAs_{1-y}P_{y} graded contact layers, all grown on InP For Ga₁₋ₓInₓAs_{1-y}P_{y}, "x" is a fraction of indium that decreases from an InP contact layer to an InGaAs carrier generation layer, "1-x" is a fraction of gallium that increases from the InP contact layer to an InGaAs carrier generation layer, "y" is a fraction of phosphorous that decreases from an InP contact layer to the InGaAs carrier generation layer, "1-y" is a fraction of arsenic that increases from an InP contact layer to an InGaAs carrier generation layer.

In this specification, elements may be described as "configured to" perform one or more functions or "configured for" such functions. In general, an element that is configured to perform or configured for performing a function is enabled to perform the function, or is suitable for performing the function, or is adapted to perform the function, or is operable to perform the function, or is otherwise capable of performing the function.

It is understood that for the purpose of this specification, language of "at least one of X, Y, and Z" and "one or more of X, Y and Z" can be construed as X only, Y only, Z only, or any combination of two or more items X, Y, and Z (e.g., XYZ, XY, YZ, XZ, and the like). Similar logic can be applied for two or more items in any occurrence of "at least one..." and "one or more..." language.

The terms "about", "substantially", "essentially", "approximately", and the like, are defined as being "close to", for example as understood by persons of skill in the art. In some examples, the terms are understood to be "within 10%," in other examples, "within 5%", in yet further examples, "within 1%", and in yet further examples "within 0.5%".

Persons skilled in the art will appreciate that there are yet more alternative examples and modifications possible, and that the above examples are only illustrations of one or more embodiments. The scope, therefore, is only to be limited by the claims appended hereto.

## Claims

1. A photodiode (200; 300; 400; 500) comprising:
a carrier generating region (206) comprising a semiconductor having a bandgap that absorbs light (205; 505) of a given wavelength, such that electrical charge carriers (215, 217) are generated in the carrier generating region by the light of the given wavelength;
an n-doped semiconductor region (210; 510) and a p-doped semiconductor region (208; 508) having respective bandgaps higher than the bandgap of the carrier generating region, the respective bandgaps being transparent to the light of the given wavelength, the n-doped semiconductor region and the p-doped semiconductor region being along different sides of the carrier generating region; and
an interface region (211; 311; 411; 511) between the carrier generating region and a given doped region of the n-doped semiconductor region or the p-doped semiconductor region, the interface region comprising one or more of a semiconductor alloy and a semiconductor sequence that is one or more of graded and stepped in composition, selected to reduce a band offset (222, 224; 322, 224; 422, 224) between the carrier generating region and the given doped region adjacent the interface region.

2. The photodiode of claim 1, wherein the semiconductor of the carrier generating region comprises a carrier-generating semiconductor and the given doped region comprises a transparent semiconductor different from the carrier-generating semiconductor,
wherein the interface region comprises a graded alloy of the carrier-generating semiconductor and the transparent semiconductor,
wherein, in the interface region, content of the carrier-generating semiconductor in the graded alloy decreases from the carrier generating region to the given doped region, and respective content of the transparent semiconductor in the graded alloy increases from the carrier generating region to the given doped region.

3. The photodiode of claim 1, wherein the semiconductor of the carrier generating region comprises a carrier-generating semiconductor and the given doped region comprises a transparent semiconductor different from the carrier-generating semiconductor,
wherein, in the interface region, content of the carrier-generating semiconductor in the steps decreases from the carrier generating region to the given doped region, and respective content of the transparent semiconductor in the steps increases from the carrier generating region to the given doped region.

4. The photodiode from claim 1, wherein, the semiconductor of the carrier generating region comprises a carrier-generating semiconductor and the given doped region comprises a transparent semiconductor different from the carrier-generating semiconductor,
and wherein the interface region comprises at least one step in respective content of the carrier-generating semiconductor and the transparent semiconductor.

5. The photodiode of any one of the preceding claims, wherein the interface region provides one or more band offset steps in the band offset between the carrier generating region and the given doped region.

6. The photodiode of any one of the preceding claims, wherein the interface region is formed from a portion of the carrier generating region closest to the given doped region.

7. The photodiode of any one of claims 1 through 5, wherein the interface region is formed from a portion of the given doped region closest to the carrier generating region.

8. The photodiode of any one of the preceding claims, wherein the semiconductor of the carrier generating region comprises carrier-generating germanium and the given doped region comprises the p-doped semiconductor region, the p-doped semiconductor region comprising p-doped silicon.

9. The photodiode of any one of claims 1 through 7, wherein the interface region is between the carrier generating region and the p-doped semiconductor region, such that carriers for which the band offset is reduced comprise holes.

10. The photodiode of any one of claims 1 through 7, wherein the interface region is between the carrier generating region and the n-doped semiconductor region, such that carriers for which the band offset is reduced comprise electrons.

11. The photodiode of any one of claims 1 through 7, wherein the n-doped semiconductor region and the p- doped semiconductor region are on opposite sides of the carrier generating region, with the interface region between the carrier generating region and one of the n-doped semiconductor region and the p- doped semiconductor region.

12. The photodiode of any one of claims 1 through 7, wherein the n-doped semiconductor region and the p- doped semiconductor region are on adjacent sides of the carrier generating region, with the interface region between the carrier generating region and one of the n-doped semiconductor region and the p- doped semiconductor region.
